Europäisches Patentamt

(19) European Patent Office

Office européen des brevets

(11) Numéro de publication: **0 060 151**
**B1**

## (12) FASCICULE DE BREVET EUROPEEN

(45) Date de publication du fascicule du brevet:
**11.07.84**

(21) Numéro de dépôt: **82400148.1**

(22) Date de dépôt: **27.01.82**

(51) Int. Cl.³: **C 30 B 35/00,** C 30 B 23/02,
H 01 L 21/68

---

(54) Installation de traitement de matériaux pour la production de semi-conducteurs.

---

(30) Priorité: **27.01.81 FR 8101486**

(43) Date de publication de la demande:
**15.09.82 Bulletin 82/37**

(45) Mention de la délivrance du brevet:
**11.07.84 Bulletin 84/28**

(84) Etats contractants désignés:
**DE FR GB**

(56) Documents cités:
**FR - A - 1 597 032**
**US - A - 4 141 458**

**IBM TECHNICAL DISCLOSURE BULLETIN, vol. 17, no. 8,
janvier 1975, NEW YORK (US) Y. BUDO et al. "Modulator
vacuum system", pages 2268 et 2269**

(73) Titulaire: **INSTRUMENTS S.A., 27, rue de la
Rochefoucauld, F-75009 Paris (FR)**

(72) Inventeur: **Bouchaib, Pierre, 32 rue de Saint Nom,
F-78620 l'Etang la Ville (FR)**

(74) Mandataire: **Dupuy, Louis et al, CREUSOT-LOIRE 15 rue
Pasquier, F-75383 Paris Cedex 8 (FR)**

ACTORUM AG

## Description

La présente invention concerne une installation de traitement de matériaux en vue de la production industrielle de semi-conducteurs pour les applications de l'électronique. Elle présente un intérêt tout particulier pour le traitement de plaquettes circulaires ou «tranches» de semi-conducteurs cristallins par le processus dit d'épitaxie par jets moléculaires.

Un tel processus connu, dont les phases essentielles sont conduites sous vide poussé, comporte principalement le passage de la «tranche» dans une chambre de dépôt où, par projection moléculaire, on forme la couche active qui sera ensuite découpée pour constituer les composants semi-conducteurs. Diverses opérations, préparatoires ou complémentaires, précèdent ou suivent l'opération de dépôt, ces diverses opérations (chauffage, analyse, bombardement ionique ..., par exemple) pouvant d'ailleurs varier selon la nature ou la destination finale des produits ainsi élaborés.

A l'heure actuelle, les installations connues comportent une chambre d'introduction, et une chambre intermédiaire avant la chambre de dépôt, chaque chambre étant reliée à des équipements de mise sous vide, avec des vannes d'isolement entre les chambres qui peuvent être amenées à se trouver à des pressions différentes. Le cheminement d'une tranche, entre son introduction et sa sortie par la même chambre, constitue donc un aller et retour par la même voie, de sorte que l'on est obligé d'attendre que l'ensemble du processus soit terminé pour pouvoir opérer sur la tranche suivante. Il en résulte des temps morts importants pour le fonctionnement de la chambre de dépôt ou des appareils de traitements auxiliaires ainsi que des pertes de vide qui obligent à un fonctionnement accru des pompes à vide, et en définitive un mauvais rendement industriel de l'installation.

On a déjà cherché à remplacer l'introduction tranche par tranche dans l'installation, par l'introduction de «cassettes» c'est-à-dire de supports sur lesquels on peut disposer simultanément plusieurs tranches, qui sont ensuite manipulées ensemble ou une par une, selon que les phases du processus doivent s'effectuer en masse ou individuellement. L'utilisation de cassettes permet déjà de réduire le nombre d'ouvertures à l'air libre de la chambre d'introduction, et par conséquent l'utilisation des pompes à vide; mais on est toujours obligé d'attendre le traitement complet de toutes les tranches d'une cassette avant de pouvoir procéder au rechargement par une nouvelle cassette. Il subsiste donc des temps morts pour certains des appareils, peu compatibles avec la nécessité d'augmenter les cadences de production.

L'invention permet, en particulier par une circulation plus continue des tranches, une utilisation plus efficace des différents appareils et une amélioration du rendement industriel de l'installation.

L'invention s'applique à une installation de traitement de matériaux pour la production de semi-conducteurs à partir de tranches de matériaux cristallins, regroupées en cassettes portant plusieurs tranches à la fois, les divers traitements étant réalisés dans des chambres raccordées à des équipements de mise sous vide, raccordées entre elles par des vannes d'isolement et raccordées à l'extérieur par au moins une porte étanche d'introduction des cassettes.

Selon l'invention l'installation est réalisée sous forme modulaire, chaque module incluant une desdites chambres et comportant:

– une partie tubulaire cylindrique rectiligne communiquant avec les appareils de traitement desdites tranches, disposés latéralement de part et d'autre de ladite partie tubulaire cylindrique, l'ensemble des parties cylindriques étant raccordées les unes aux autres en un tunnel continu, avec interposition de vannes d'isolement entre modules destinés à travailler sous des pressions différentes,

– une portion de rail intérieur disposée de la même façon parallèlement à l'axe de la partie cylindrique de façon à constituer dans le tunnel continu une succession de portions de rails alignés interrompus au droit des raccordements des modules, les cassettes étant par ailleurs constituées en forme de chariot, la position des roues du chariot et le profil du rail étant déterminés de façon à maintenir le chariot sur une portion du rail lorsqu'une partie du chariot franchit une interruption du rail,

– des moyens, commandés de l'extérieur, pour entraîner le déplacement d'une cassette sur les rails, déterminés de telle sorte qu'une cassette soit prise en charge par le dispositif propre à un module avant d'avoir été relachée par le dispositif propre au module précédent,

– des moyens commandés de l'extérieur et raccordés latéralement à ladite partie tubulaire cylindrique, pour manipuler individuellement les tranches d'une cassette, entre la cassette et l'appareil associé au module, ou entre emplacements différents de la cassette.

L'invention sera mieux comprise en se référant à un mode de réalisation particulier donné à titre d'exemple et représenté par les dessins annexés.

La figure 1 est une vue d'ensemble simplifiée d'une chaîne réalisée selon l'invention pour la mise en œuvre du processus d'épitaxie par jets moléculaires pour des tranches de semi-conducteurs cristallins.

Les figures 2 et 3 représentent une telle tranche montée sur un support de manipulation. La figure 2 est une vue de l'ensemble, côté support selon II-II de la figure 3. La figure 3 est une vue de profil de l'ensemble.

La figure 4 est une coupe transversale simplifiée de la chaine, selon IV-IV de la figure 1.

La figure 5 est une coupe longitudinale selon V-V de la figure 4, et montre le passage d'une cassette d'une section à une autre de la chaîne.

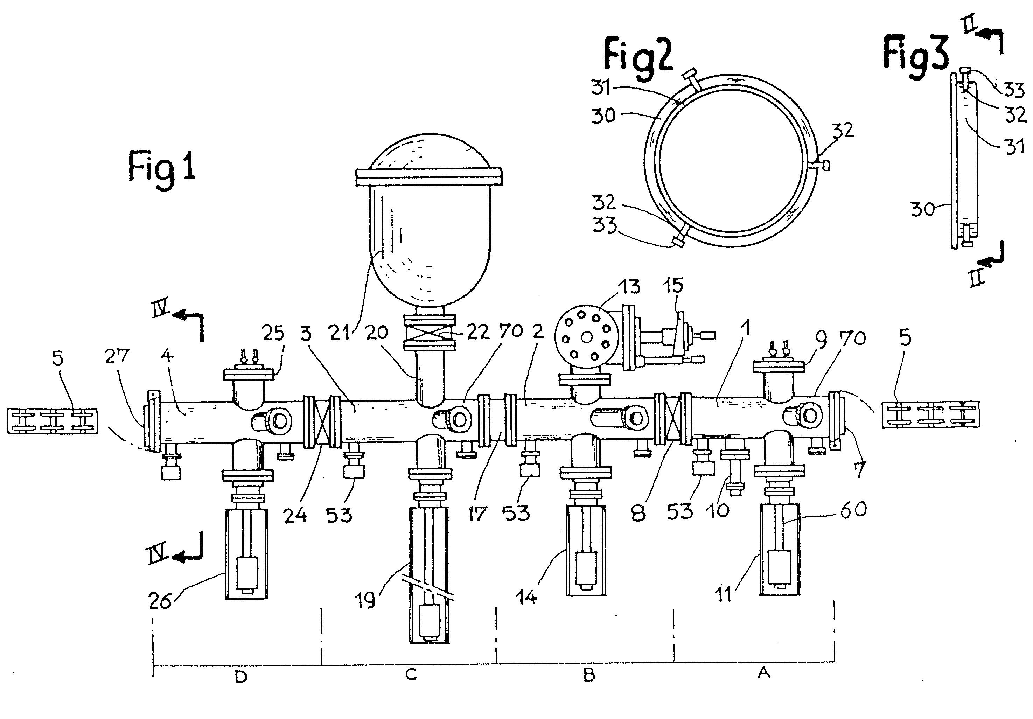

En se référant tout d'abord à la figure 1, la chaîne de traitement représentée sommairement dans son ensemble est de structure générale modulaire, avec ici quatre modules successifs A, B, C et D. Chaque module comporte un tronçon principal de passage 1, 2, 3, 4 en forme de tube cylindrique rectiligne, avec divers appareils de traitement, d'entrainement ou de manipulation disposés latéralement de part et d'autre du tronçon cylindrique. Les quatre tronçons 1, 2, 3, 4 sont raccordés en alignement pour constituer un tunnel continu interrompu par des vannes d'isolement entre certains modules et obturé à chaque extrémité par des portes étanches. L'intérieur de chaque module est raccordé de façon tout-à-fait usuelle à une pompe à vide, et pour ne pas surcharger les dessins simplifiés on n'a pas représenté ces raccordements.

Les tranches à traiter sont préalablement disposées en cassettes sur des chariots tels que 5 qui seront décrits plus en détail ultérieurement, ainsi que les moyens utilisés pour le cheminement des cassettes à travers tous les modules.

Le module A est ici un module de chargement des cassettes dans la chaine et de préparation des tranches. Il comporte une porte d'introduction 7 et est séparé du module B par une vanne d'isolement 8. On trouve sur ce module A des appareils de préparation des tranches, comme un poste de chauffage 9 et un poste de nettoyage par bombardement ionique 10. A ce module est aussi associé un appareil 11 à barre de transfert pour la manipulation des tranches à l'intérieur du module.

Le module suivant B est un module d'analyse équipé d'un poste 13 d'analyse de la surface des tranches, par exemple par spectrométrie d'énergie. Il comporte aussi un appareil à barre de transfert 14, analogue à l'appareil 11 du module A. Un autre équipement de manipulation 15 est associé à l'appareil d'analyse 13.

Le module B est relié au module suivant C par un simple manchon de raccordement 17, sans vanne d'isolement. On observera que l'encombrement du manchon ouvert 17 est le même que celui d'une vanne d'isolement comme la vanne 8 entre les modules A et B.

Le module C est un simple module de transfert équipé d'un appareil à barre de transfert 19, de même type que les appareils 11 ou 14, mais à plus longue portée. Face à l'appareil 19 le manchon comporte une conduite 20 qui aboutit à la chambre de dépôt 21 avec interposition d'une vanne d'isolement 22.

Enfin le module D, relié au module C par la vanne d'isolement 24, est un module d'extraction des cassettes 5 en sortie de la chaine. Elle comporte, comme le module A, un poste de chauffage 25 et un appareil à barre de transfert 26, et est obturé à son extrémité par la porte de sortie 27.

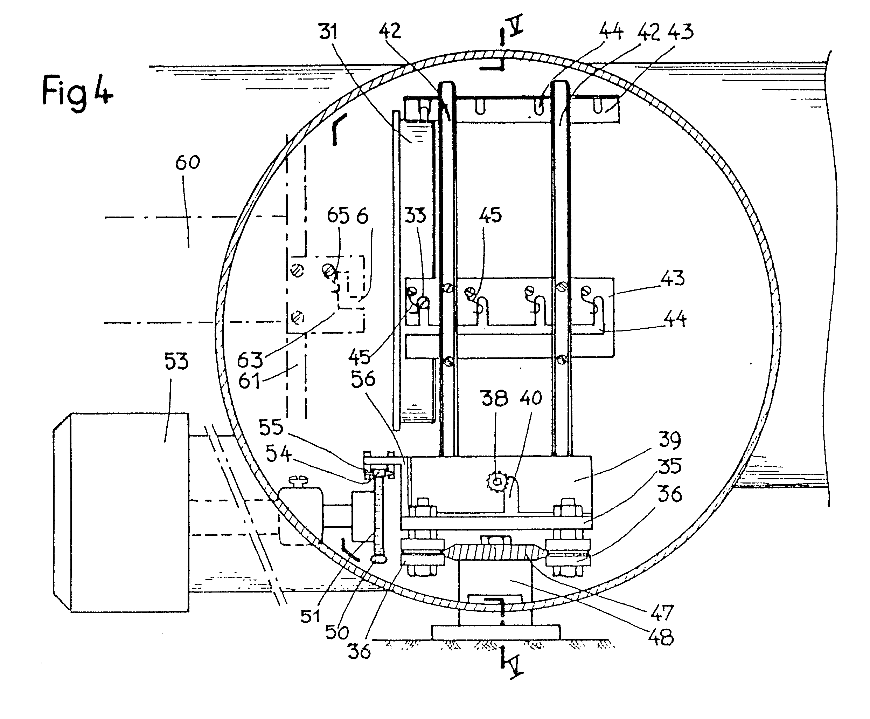

On se référera maintenant aux figures 2 et 3 qui montrent la constitution d'une tranche à traiter dans l'installation. La tranche proprement dite 30 de matériau semi-conducteur cristallin est solidarisée à un support métallique 31 en forme d'anneau plat. L'anneau 31 porte trois broches radiales 32, angulairement équidistantes et terminées chacune par une tête 33.

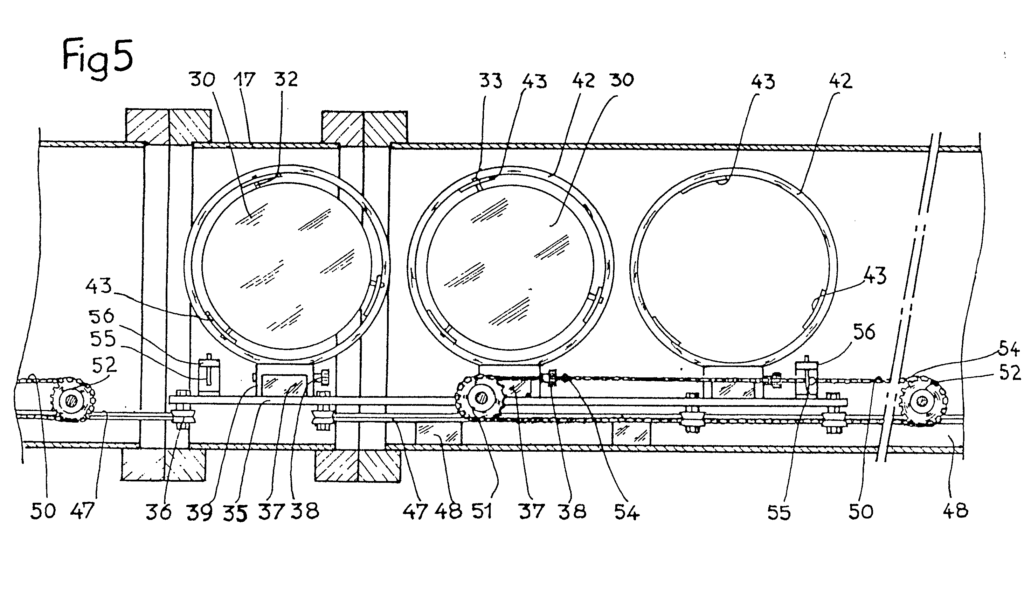

Les figures 4 et 5 montrent la structure d'une cassette support de tranches; elle est représentée en élévation transversale sur la figure 5 et en vue en bout sur la figure 4. La cassette comporte une plaque support 35 munie à chaque extrémité d'un jeu de quatre roues folles à axe vertical 36. Chaque roue 36 est en forme générale de diabolo, avec une gorge trapézoïdale médiane. La plaque 35 supporte trois blocs de centrage 37, avec une vis latérale en saillie 38. Les supports directs des tranches sont constitués par des ensembles portés chacun par une chape 39 qui vient coiffer un support 37 sur lequel elle est positionnée par une rainure à baïonnette 40 et bloquée par serrage de la vis 38. La chape 39 supporte deux cerceaux verticaux 42, reliés par trois plaques cintrées 43 angulairement équidistantes et présentant chacune une découpe en peigne 44, ouverte à une extrémité. Chaque tranche est mise en place sur la cassette, comme on le voit surtout sur la figure 4, en engageant les broches 32 chacune dans une rainure 44 jusqu'à être en face d'une dent du peigne, puis par une légère rotation, les trois broches pénètrent simultanément dans la même dent des trois plaques 43. La face intérieure des têtes 33 est à une distance du centre de la tranche à peine supérieure au rayon extérieur des plaques cintrées 43, si bien que les tranches sont maintenues en position angulaire par encliquetage des petits ressorts 45 sur les têtes 33 lorsque les broches 32 sont engagées à fond dans les dents du peigne.

La cassette porte tranches qui vient d'être décrite est supportée, à l'intérieur des modules, par les rails plats 47 dont les extrémités en biseau viennent s'engager dans les gorges trapézoïdales des roues folles 36. Chaque module A, B, C, D, comporte un tel rail 47 porté par des supports 48 fixés à la paroi du module. Comme on le voit plus particulièrement sur la figure 4, dans chaque module le rail 47 déborde légèrement au-delà de l'extrémité du module, mais la présence entre deux modules, soit d'un manchon de raccordement comme 17, soit d'une vanne d'isolement comme 24, entraîne une discontinuité entre deux rails 47 de deux modules consécutifs, discontinuité nécessaire pour permettre la fermeture de la vanne s'il y a lieu. Cependant la disposition des biseaux latéraux du rail engagés dans les gorges des roues 36 permet de maintenir le chariot-cassette sur le rail, même si l'une des extrémités du chariot se trouve en porte-à-faux au-dessus d'une discontinuité du rail, et le chariot peut franchir ces discontinuités. Les roues avant s'engagent sur le rail aval avant que les roues arrière aient quitté le rail amont.

Le déplacement d'un chariot à l'intérieur d'un module ou d'un module à l'autre est ici assuré par un dispositif à chaîne sans fin 50. La chaîne 50 est enroulée entre un pignon à chaîne moteur 51 et un pignon de renvoi 52. Le pignon moteur 51 est entraîné à partir d'un moteur extérieur 53. La chaîne 50 porte, à intervalles réguliers, des taquets 54 dont les parties latérales débordantes viennent au contact de butées 55, qui entourent la chaîne 50 à la manière d'une chape à partir de supports 56 solidaires de la plaque de base 35 du chariot.

Pour bien comprendre le mode de fonctionnement et les avantages de l'installation qui vient d'être décrite, on supposera qu'une cassette 5 vient d'être introduite dans le module d'introduction A. Sur les trois supports circulaires de tranches, deux seulement sont remplis de tranches et le troisième est vide. Une fois la porte 7 fermée, et le vide établi dans le module A, par exemple à $1,33.10^{-12}$ bar, il s'agit d'amener une par une chaque tranche au poste de chauffage 9. Pour cela le dispositif à barre de transfert 9, manipulable de l'extérieur, comporte une barre traversante 60 qui à l'intérieur du module se termine par un plateau circulaire 61 (figure 4). Le plateau 61 porte à sa périphérie trois plaques cintrées 63 analogues aux plaques 43 mais avec une découpe 64 à une seule dent, et munies chacune d'un ressort d'encliquetage 65 analogue aux ressorts 45 de la cassette. On engage d'abord les découpes 64 du plateau 61 sur les broches 32 d'une tranche, puis on fait tourner le plateau 61 pour amener les broches en fond de dent 64 où elles sont retenues par les ressorts 65. En continuant à tourner on peut libérer les broches 32 des ressorts 45, puis les amener dans l'axe de la rainure rectiligne 44. La tranche est alors solidarisée avec le plateau 61, et en tirant on libère totalement la tranche de la cassette. Par un déplacement longitudinal de la cassette on libère le passage pour amener la tranche au poste de chauffage 9, où par une manœuvre inverse elle est mise en place sur un support du même type à baïonnette.

Après chauffage, et par les mêmes moyens, la tranche est remise en attente sur un poste vide de la cassette, et une nouvelle manipulation peut être opérée sur une autre tranche. Bien entendu les barres de transfert 60 comportent des repères d'indexation axiale et angulaire pour venir placer les plaques de préhension 63 en position voulue pour prélever ou remettre en place les tranches aux emplacements voulus sur la cassette. Les manipulations peuvent être facilitées par un examen direct à travers les hublots 70.

Lorsque toutes les tranches ont été traitées aux postes de chauffage 9 et de nettoyage 10, on ouvre la vanne 8 et l'on transfère la cassette dans le module B. On notera que pendant le transfert le chariot-cassette sera pris en charge par les taquets 54 de la chaîne aval qui s'engageront sur les butées 55 avant du chariot avant que les butées 55 arrière aient été libérées par les taquets 54 de la chaîne amont. Après la fermeture de la vanne 8, le module A est prêt pour recevoir une nouvelle cassette sans attendre que toutes les tranches de la cassette précédente aient subi la totalité du processus de traitement. Il en sera de même à chaque étape dans un nouveau module où les manipulations tranche par tranche s'effectuent de la même façon au moyen des dispositifs à broches de transfert 14, 19 et 26, jusqu'à la sortie par la porte d'évacuation 27.

On voit que dans chaque module on peut commencer à traiter les tranches d'une nouvelle cassette dès que la cassette précédente a pu être transférée au module suivant, si bien que tous les appareils de la chaîne peuvent travailler avec le minimum de temps morts. Selon les durées relatives des opérations de chaque appareil, on pourrait aussi envisager de mettre en parallèle deux modules identiques chacun ne traitant que la moitié des tranches qui le traversent.

Bien entendu l'invention n'est pas strictement limitée au mode de réalisation qui a été décrit à titre d'exemple, mais elle couvre aussi les réalisations qui n'en différeraient que par des détails, par des variantes d'exécution ou par l'utilisation de moyens équivalents.

**Revendication**

1. Installation de traitement de matériaux pour la production de semi-conducteurs à partir de tranches de matériaux cristallins, regroupées en cassettes portant plusieurs tranches à la fois, les divers traitements étant réalisés dans des chambres raccordées à des équipements de mise sous vide, raccordées entre elles par des vannes d'isolement et raccordées à l'extérieur par au moins une porte étanche d'introduction des cassettes, caractérisée par le fait que l'installation est réalisée sous forme modulaire, chaque module (A, B, C, D) incluant une desdites chambres et comportant:

– une partie tubulaire cylindrique rectiligne (1, 2, 3, 4), communiquant avec les appareils de traitement desdites tranches, disposés latéralement de part et d'autre de ladite partie tubulaire cylindrique, l'ensemble des parties cylindriques étant raccordées les unes aux autres en un tunnel continu, avec interposition de vannes d'isolement (8, 24) entre modules destinés à travailler sous des pressions différentes,
– une portion de rail intérieur (47) disposée de la même façon parallèlement à l'axe de la partie cylindrique de façon à constituer dans le tunnel continu une succession de portions de rails alignés interrompus au droit des raccordements des modules, les cassettes étant par ailleurs constituées en forme de chariot (5), la position des roues (36) du chariot et le profil du rail (47) étant déterminés de façon à maintenir le chariot sur une portion du rail lorsqu'une partie du chariot franchit une interruption du rail,
– des moyens (50, 51), commandés de l'extérieur, pour entraîner le déplacement d'une cassette sur le rail, déterminés de telle sorte qu'une cassette soit prise en charge par le dispositif propre à un module avant d'avoir été relachée par le dispositif propre au module précédent,
– des moyens (61, 63) commandés de l'extérieur et raccordés latéralement à ladite partie tubulaire cylindrique pour manipuler individuellement les tranches d'une cassette, entre la cassette et l'appareil associé au module, ou entre emplacements différents de la cassette.

## Claim

1. Equipment for processing materials for the production of semiconductors, starting from wafers of crystalline materials rearranged in cassettes carrying several wafers at the same time, the various processes being carried out in chambers which are connected to equipments for applying a vacuum, are connected to each other by isolation valves and are connected to the outside by at least one leaktight door for introducing the cassettes, characterised in that the equipment is produced in a modular from, each module (A, B, C, D) including one of the said chambers and comprising:

– a rectilinear cylindrical tubular part (1, 2, 3, 4) communicating with the devices for processing the said wafers, arranged laterally on either side of the said cylindrical tubular part, the group of the cylindrical parts being connected to each other as a continuous tunnel, with interposition of isolating valves (8, 24) in between modules which are intended to operate under different pressures,
– an internal rail section (47) arranged in the same manner parallel to the axis of the cylindrical part so as to form, in the continuous tunnel, a sequence of aligned rail sections interrupted at right angles to the junctions of the modules, the cassettes being moreover constructed in the form of a trolley (5), the position of the trolley wheels (36) and the outline of the rail (47) being determined so as to maintain the trolley on a rail section when a part of the trolley crosses an interruption in the rail,
– means (50, 51), controlled from the outside, for producing the movement of a cassette on the rail, determined so that a cassette is taken under control by the device fitted to a module before being released by the device fitted to the preceding module, and
– means (61, 63), controlled from the outside and connected laterally to the said cylindrical tubular part, for handling individually the wafers of a cassette, between the cassette and the device associated with the module, or between different locations on the cassette.

## Patentanspruch

1. Materialienbehandlungsanlage für die Halbleiterherstellung aus Scheiben kristalliner Materialien, die in gleichzeitig mehrere Scheiben aufnehmende Kassetten zusammengefasst sind, wobei die verschiedenen Behandlungsphasen in an Vakuumgeräte angeschlossene Kammern durchgeführt werden, die über Absperrschieber miteinander und mindestens über eine abgedichtete Tür zur Einführung der Kassetten nach aussen hin verbunden sind, dadurch gekennzeichnet, dass die Anlage als Baukastensystem ausgeführt ist, wobei jedes Modul (A, B, C, D) jeweils eine dieser Kammern aufnimmt und – ein geradliniges Zylinderrohrteil (1, 2, 3, 4) umfasst, das mit der Behandlungsapparatur dieser an beiden Seiten des Zylinderrohrteils angeordneten Scheiben in Verbindung steht, und wobei sämtliche Zylinderteile als kontinuierliches Tunnel unter Zwischenschaltung von Absperrschiebern (8, 24) zwischen den mit unterschiedlichen Drücken arbeitenden Bausteinen aneinander angeschlossen sind, – sowie ein auf die selbe Art und Weise parallel zur Zylinderteilachse angeordneter innerer Schienenabschnitt (47) um somit in dem kontinuierlichen Tunnel eine Folge ausgerichteter Schienenabschnitte zu bilden, die rechtwinklig zu den Bausteinanschlüssen unterbrochen sind, wobei die Kassetten übrigens als Wagen (5) ausgebildet sind und die Stellung der Räder (36) des Wagens und das Profil der Schienen (47) derart bestimmt sind, dass ein Schienenabschnitt den Wagen aufnimmt, wenn ein Wagenteil eine Schienenunterbrechung überfährt, – sowie zum Verfahren einer Kassette auf der Schiene von aussen gesteuerte Mittel (50, 51), die derart festgelegt sind, dass eine Kassette von der einem Modul zugeordneten Vorrichtung übernommen wird, bevor sie von der dem vorhergehenden Modul zugeordneten Vorrichtung freigegeben wird, und – von aussen gesteuerte, seitlich an dieses Zylinderrohrteil angeschlossene Mittel (61, 63) um zwischen der Kassette und dem dem Modul zugeordneten Gerät oder zwischen unterschiedlichen Lagen der Kassette die Scheiben einer Kassette einzeln zu handhaben.

Fig3

Fig2

Fig1

Fig 4

Fig 5